# EUROPEAN PATENT APPLICATION

(11) **EP 4 593 123 A1**
(43) Date of publication of application: **30.07.2025**
(21) Application number: 23917225.7
(22) Date of filing: 29.11.2023
(51) Int. Cl.: H01M 4/66

(54) **NEGATIVE ELECTRODE CURRENT COLLECTOR AND PREPARATION METHOD THEREFOR, NEGATIVE ELECTRODE SHEET, SECONDARY BATTERY, AND ELECTRIC DEVICE**

(30) Priority: 18.01.2023 CN 202310079216
(71) Applicant: Contemporary Amperex Technology (Hong Kong) Limited, Central (HK)
(72) Inventor: FENG, Fuxiang, Ningde, Fujian 352100 (CN); GUAN, Wenhao, Ningde, Fujian 352100 (CN); ZHONG, Wei, Ningde, Fujian 352100 (CN)
(74) Representative: Kraus & Lederer PartGmbB
(86) International application number: PCT/CN2023/135197
(87) International publication number: WO 2024/152757

(57) **Abstract**

**This application** relates to a negative current collector. At least one surface of the negative current collector is overlaid with a LiₓM alloy layer, in which 0 < x ≤ 4.4 and M includes at least one selected from Group **III** elements, Group IV elements, magnesium, zinc, vanadium, iron, cobalt, phosphorus, or sulfur. This application further relates to a preparation method of the negative current collector, a negative electrode plate, a secondary battery, and an electrical device. The negative current collector of this application contains a pre-lithiation layer, and can improve lithium affinity of the current collector surface, induce uniform deposition of lithium, and compensate for loss of active lithium caused during chemical formation, thereby improving the first-cycle Coulombic efficiency of the secondary battery. In addition, the lithium content in the pre-lithiation layer can be adjusted as required, thereby implementing precise lithium supplementation and improving the cycle life of the secondary battery.

## Description

### CROSS-REFERENCE TO RELATED APPLICATIONS

This application is based on and claims priority to Chinese Patent Application No. 2023100792160, filed on January 18, 2023 and titled "NEGATIVE CURRENT COLLECTOR AND PREPARATION METHOD THEREOF, NEGATIVE ELECTRODE PLATE, SECONDARY BATTERY, AND ELECTRICAL DEVICE", which is incorporated herein by reference in its entirety.

### TECHNICAL FIELD

This application relates to the technical field of secondary batteries, and in particular, to a negative current collector and a preparation method thereof, a negative electrode plate, a secondary battery, and an electrical device.

### BACKGROUND

In recent years, lithium-ion batteries have been applied more extensively in many fields, including energy storage power systems such as hydro, thermal, wind, and solar power stations, and other fields such as electric tools, electric bicycles, electric motorcycles, and electric vehicles, military equipment, and aerospace. Among all metal elements, lithium metal is a metal with the smallest relative atomic mass (6.94) and the lowest standard electrode potential (-3.045 V). A theoretical gravimetric capacity of the lithium metal is up to 3860 mAh/g. Therefore, the lithium metal used as a negative electrode of the battery in conjunction with some positive materials of a high energy density can greatly increase the energy density and working voltage of the battery. However, to commercialize the battery that uses the lithium metal as a negative electrode material, the first-cycle Coulombic efficiency and the cycle life need to be improved. Therefore, how to improve the first-cycle Coulombic efficiency and cycle life of a lithium metal battery is still a pressing challenge in this field.

### SUMMARY

This application is developed in view of the above challenge. An objective of this application is to provide a negative current collector to improve the first-cycle Coulombic efficiency and cycle life of a lithium metal battery.

To achieve the above objective, a first aspect of this application provides a negative current collector. At least one surface of the negative current collector is overlaid with a LiₓM alloy layer, in which 0 < x ≤ 5 and M includes at least one selected from Group III elements, Group IV elements, magnesium, zinc, vanadium, iron, cobalt, phosphorus, or sulfur.

The negative current collector of this application can improve the first-cycle Coulombic efficiency and cycle life of the lithium metal battery significantly.

In any embodiment, a thickness of the alloy layer is 5 nm to 6000 nm, and optionally 10 nm to 5000 nm.

In any embodiment, a mass per unit area of the alloy layer is 0.10 g/m² to 35 g/m², and optionally 0.20 g/m² to 30.0 g/m².

The alloy layer of this application can improve the lithium affinity of the current collector and the uniformity of lithium deposition, and can also supplement active lithium, thereby improving the first-cycle Coulombic efficiency and cycle performance of the battery.

In any embodiment, a lithium oxide layer is further disposed on one side of the alloy layer, the side being away from the current collector; and a thickness of the lithium oxide layer is 1 nm to 1000 nm, and optionally 10 nm to 500 nm.

In any embodiment, a mass per unit area of the lithium oxide layer is 0.5 g/m² to 20 g/m², and optionally 1 g/m² to 10 g/m².

The lithium oxide layer of this application can cover and protect the alloy layer, isolate the air, and improve the stability of the alloy layer in the air.

In any embodiment, the current collector is at least one selected from copper foil, copper mesh, or foamed copper.

A second aspect of this application provides a method for preparing a negative current collector. The method includes the following steps:
(1) dissolving a reactant in a solvent, and then adding metallic lithium to obtain a lithiation agent;
(2) depositing a MₙO_{y} (where 1 ≤ n ≤ 3, 0 ≤ y ≤ 5) layer on the current collector by magnetron sputtering to obtain a current collector containing a lithium-philic layer, where M includes at least one selected from Group III elements, Group IV elements, magnesium, zinc, vanadium, iron, cobalt, phosphorus, or sulfur; and
(3) applying the lithiation agent obtained in step (1) to the lithium-philic layer obtained in step (2), so as to obtain a current collector containing a pre-lithiation layer.

In any embodiment, in step (1), the lithiation agent is a lithium-reactant-solvent complex.

In any embodiment, in step (1), the reactant includes at least one selected from naphthalene, biphenyl, phenanthrene, anthracene, perylene, pyrene, fluorene, indene, or an alkyl substituent thereof; and optionally, the reactant includes at least one selected from fluorene, biphenyl, indene, naphthalene, 9,9-dimethylfluorene, or 2,2-dimethylbiphenyl.

In any embodiment, in step (1), the solvent includes at least one selected from an aromatic compound, an ether, a furan, a pyran, an ester, or fluoride thereof; and optionally, the solvent includes at least one selected from tetrahydrofuran, monoglyme, dimethyl carbonate, ethyl 1, 1,2,2-tetrafluoroethyl ether, or 2-methyltetrahydrofuran.

By using the reactant and solvent of this application, this application can ensure that the metallic lithium forms a lithiation agent of an appropriate redox potential.

In any embodiment, in step (1), a redox potential of the lithiation agent is 0.05 V to 1.0 V, and optionally 0.1 V to 0.5 V.

By controlling the redox potential of the lithiation agent to fall within the range specified herein, this application can ensure that the lithiation agent can more easily lithiate a lithium-philic layer material on the current collector.

In any embodiment, in step (1), stirring is performed after adding the metallic lithium, and the stirring continues for a duration of 0.2 h to 12 h, and optionally 1 h to 6 h; and/or, the stirring is performed at a temperature of -10 °C to 70 °C, and optionally 0 to 60 °C; and/or, a molar ratio of the metallic lithium to the reactant is (1 to 20): 1, and optionally (2 to 15): 1.

In any embodiment, in step (2), a thickness of the MₙO_{y} layer is 2 nm to 3000 nm, and optionally 4 nm to 2500 nm; and/or, a mass per unit area of the MₙO_{y} layer is 0.1 g/m² to 25 g/m², and optionally 1 g/m² to 20 g/m².

By setting the thickness and mass of the lithium-philic layer of this application to fall within the range specified herein, this application can maintain strong binding between the lithium-philic layer and the current collector while making the current collector lithium-philic.

In any embodiment, in step (2), when y in MₙO_{y} is 0, M serving as a lithium-philic substance is a pure element, and a resultant pre-lithiation layer includes a LiₓM alloy layer; and, when 0 < y ≤ 5, the lithium-philic substance is an oxide of M, and a resultant pre-lithiation layer includes a LiₓM alloy inner layer and a Li₂O outer layer.

In any embodiment, in step (3), the lithiation agent obtained in step (1) is applied to the MₙO_{y} layer, and then the current collector is cleansed with a washing liquid after complete reaction, and is dried to obtain a current collector containing the pre-lithiation layer.

In any embodiment, in step (3), the lithiation agent is applied to the lithium-philic layer by at least one of dip-coating, brushing, curtain coating, roller coating, nitrogen spraying, air spraying, electrostatic spraying, electrophoretic spraying, or high-pressure airless spraying.

The negative current collector of this application contains a pre-lithiation layer, and can improve lithium affinity of the current collector surface, induce uniform deposition of lithium, and compensate for loss of active lithium caused during chemical formation, thereby improving the first-cycle Coulombic efficiency of the secondary battery. In addition, the lithium content in the pre-lithiation layer can be adjusted as required, thereby implementing precise lithium supplementation and improving the cycle life of the secondary battery.

A third aspect of this application provides a negative electrode plate. The negative electrode plate includes the negative current collector according to the first aspect of this application or a negative current collector prepared by the method according to the second aspect of this application.

A fourth aspect of this application provides a secondary battery. The secondary battery includes at least one of the negative current collector according to the first aspect of this application, a negative current collector prepared by the method according to the second aspect of this application, or the negative electrode plate according to the third aspect of this application.

A fifth aspect of this application provides an electrical device. The electrical device includes the secondary battery according to the fourth aspect of this application.

The electrical device according to this application contains the secondary battery according to this application, and therefore, achieves at least the same advantages as the secondary battery.

### BRIEF DESCRIPTION OF DRAWINGS

FIG. 1 is a schematic diagram of a battery cell according to an embodiment of this application;
FIG. 2 is an exploded view of a battery cell shown in FIG. 1 according to an embodiment of this application;
FIG. 3 is a schematic diagram of a battery module according to an embodiment of this application;
FIG. 4 is a schematic diagram of a battery pack according to an embodiment of this application;
FIG. 5 is an exploded view of a battery pack shown in FIG. 4 according to an embodiment of this application; and
FIG. 6 is a schematic diagram of an electrical device that uses a secondary battery as a power supply according to an embodiment of this application.

List of reference numerals:
1. battery pack; 2. upper box; 3. lower box; 4. battery module; 5. battery cell; 51. housing; 52. electrode assembly; 53. top cap assembly.

### DETAILED DESCRIPTION OF EMBODIMENTS

The following discloses and describes in detail a negative current collector, a preparation method of the negative current collector, a negative electrode plate, a secondary battery, and an electrical device according to some embodiments of this application with due reference to drawings. However, unnecessary details may be omitted in some cases. For example, a detailed description of a well-known matter or repeated description of an essentially identical structure may be omitted. That is intended to prevent the following descriptions from becoming unnecessarily lengthy, and to facilitate understanding by a person skilled in the art. In addition, the drawings and the following descriptions are intended for a person skilled in the art to thoroughly understand this application, but not intended to limit the subject-matter set forth in the claims.

A "range" disclosed herein is defined in the form of a lower limit and an upper limit. A given range is defined by a lower limit and an upper limit selected. The selected lower and upper limits define the boundaries of a particular range. A range so defined may be inclusive or exclusive of the end values, and a lower limit of one range may be arbitrarily combined with an upper limit of another range to form a range. For example, if a given parameter falls within a range of 60 to 120 and a range of 80 to 110, it is expectable that the parameter may fall within a range of 60 to 110 and a range of 80 to 120 as well. In addition, if lower-limit values 1 and 2 are listed, and if upper-limit values 3, 4, and 5 are listed, the following ranges are all expectable: 1 to 3, 1 to 4, 1 to 5, 2 to 3, 2 to 4, and 2 to 5. Unless otherwise specified herein, a numerical range "a to b" is a brief representation of a combination of any real numbers between a and b inclusive, where both a and b are real numbers. For example, a numerical range "0 to 5" herein means all real numbers recited between 0 and 5 inclusive, and the expression "0 to 5" is just a brief representation of a combination of such numbers. In addition, a statement that a parameter is an integer greater than or equal to 2 is equivalent to a disclosure that the parameter is an integer such as 2, 3, 4, 5, 6, 7, 8, 9, 10, 11, 12, and so on.

Unless otherwise expressly specified herein, any embodiments and optional embodiments hereof may be combined with each other to form a new technical solution.

Unless otherwise expressly specified herein, any technical features and optional technical features hereof may be combined with each other to form a new technical solution.

Unless otherwise expressly specified herein, all steps described herein may be performed in sequence or at random, and preferably in sequence. For example, that the method includes steps (a) and (b) indicates that the method may include steps (a) and (b) performed in sequence, or steps (b) and (a) performed in sequence. For example, that the method may further include step (c) indicates that step (c) may be added into the method in any order. For example, the method may include steps (a), (b), and (c), or may include steps (a), (c), and (b), or may include steps (c), (a), and (b), and so on.

Unless otherwise expressly specified herein, "include" and "comprise" mentioned herein mean open-ended inclusion, or closed-ended inclusion. For example, the terms "include" and "comprise" may mean inclusion of other items that are not recited, or inclusion of only the items recited.

Unless otherwise expressly specified, the term "or" used herein is inclusive. For example, the expression "A or B" means "A alone, B alone, or both A and B". More specifically, all and any of the following conditions satisfy the condition "A or B": A is true (or existent) and B is false (or absent); A is false (or absent) and B is true (or existent); and, both A and B are true (or existent).

Unless otherwise specified, contents and percentages in the context of this application are measurements by mass.

In a lithium metal secondary battery, due to a weak lithiophilic nature of the negative current collector used in the prior art, lithium ions are unable to be uniformly and rapidly nucleated, resulting in nonuniform lithium ion concentration at an interface between a negative electrode and an electrolyte solution. Consequently, current density distribution at the interface is nonuniform, deposition speed at a nucleation site is excessively fast, and a dendrite structure is formed, thereby severely impairing the first-cycle Coulombic efficiency and cycle life of the lithium metal battery.

Unexpectedly, the inventor finds that the first-cycle Coulombic efficiency and cycle life of lithium metal secondary batteries can be improved significantly by disposing the pre-lithiation layer of this application on at least one side of the negative current collector.

For this reason, a first aspect of this application provides a negative current collector. At least one surface of the negative current collector is overlaid with a LiₓM alloy layer, in which 0 < x ≤ 5 and M includes at least one selected from Group III elements, Group IV elements, magnesium, zinc, vanadium, iron, cobalt, phosphorus, or sulfur, and optionally, at least one selected from silicon, aluminum, tin, magnesium, zinc, carbon, or phosphorus.

In some embodiments, x is a value greater than 0 and less than or equal to 5, and optionally, is a value greater than or equal to 1 and less than or equal to 4.4.

In this application, understandably, the Group III elements include at least one selected from boron, aluminum, gallium, indium, or thallium; the Group IV elements include at least one selected from carbon, silicon, germanium, tin, or lead.

The negative current collector of this application can improve the first-cycle Coulombic efficiency and cycle life of the lithium metal battery significantly.

As used herein, the term "at least one surface of the negative current collector" means at least one of the two surfaces of the negative current collector in the thickness direction.

In some embodiments, the thickness of the alloy layer is 5 nm to 6000 nm, and optionally 10 nm to 5000 nm.

In some embodiments, the mass per unit area of the alloy layer is 0.10 g/m² to 35 g/m², optionally 0.20 g/m² to 30 g/m², and preferably, 2.5 g/m² to 28 g/m².

In some embodiments, a lithium oxide layer is further disposed on one side of the alloy layer, the side being away from the current collector; and a thickness of the lithium oxide layer is 1 nm to 1000 nm, optionally 10 nm to 800 nm, further optionally 50 nm to 600 nm, and preferably 100 nm to 550 nm.

In some embodiments, a thickness ratio of the alloy layer to the lithium oxide layer is (0.5 to 10): 1, optionally (1 to 6): 1, and further optionally (2 to 4): 1.

In this application, the thicknesses of the alloy layer and the lithium oxide layer on the alloy layer may be measured by a scanning electron microscopy & energy-dispersive spectroscopy (SEM-EDS) or X-ray photoelectron spectroscopy (XPS) sputtering depth profiling technique.

As used herein, the term "pre-lithiation layer" includes an alloy layer formed on at least one side of the current collector and optionally a lithium oxide layer formed on one side, away from the current collector, of the alloy layer. The alloy layer is formed by reacting a material of a lithium-philic layer (that is, the oxide of M, denoted by MₙO_{y}) with a lithiation agent.

In some embodiments, a mass per unit area of the lithium oxide layer is 0.5 g/m² to 20 g/m², and optionally 1 g/m² to 10 g/m².

In this application, the mass of the lithium-philic layer (that is, the MₙO_{y} layer), the mass of the alloy layer, and the mass of the lithium oxide layer may be measured by a method similar to an areal density measurement method. For example, the mass of the lithium-philic layer can be calculated by determining a difference between the mass of the current collector per unit area before the sputtering of the lithium-philic layer and the mass of the current collector per unit area after the sputtering of the lithium-philic layer. Similarly, the mass of the pre-lithiation layer can be calculated by determining a difference between the mass of the current collector per unit area before the lithiation agent is applied and the mass of the current collector per unit area after the lithiation agent is applied. The mass of the alloy layer and the mass of the lithium oxide layer may be calculated based on a specific reaction equation or calculated by determining the thicknesses of the alloy layer and the lithium oxide layer, converting the thicknesses into a volume value, and then multiplying the volume by the density.

In some embodiments, the current collector is at least one selected from copper foil, copper mesh, or foamed copper, and optionally is copper foil.

In this application, the current collector of this application may be optionally pre-treated before sputtering, for example, may be subjected to mechanical polishing and washing in a solvent, so as to undergo vacuum sputtering more favorably.

A second aspect of this application provides a method for preparing a negative current collector. The method includes the following steps:
(1) dissolving a reactant in a solvent, and then adding metallic lithium to obtain a lithiation agent;
(2) depositing a MₙO_{y} (where 1 ≤ n ≤ 3, 0 ≤ y ≤ 5) layer on the current collector by magnetron sputtering to obtain a current collector containing a lithium-philic layer, where M includes at least one selected from Group III elements, Group IV elements, magnesium, zinc, vanadium, iron, cobalt, phosphorus, or sulfur; and
(3) applying the lithiation agent obtained in step (1) to the lithium-philic layer obtained in step (2), so as to obtain a current collector containing a pre-lithiation layer.

In some embodiments, in step (1), the lithiation agent is a lithium-reactant-solvent complex. In this application, as an alternative, the lithiation agent may be purchased directly.

In some embodiments, in step (1), the reactant includes at least one selected from naphthalene, biphenyl, phenanthrene, anthracene, perylene, pyrene, fluorene, indene, or an alkyl substituent thereof. Optionally, the reactant includes at least one selected from 2-methylnaphthalene, 2,2-dimethylbiphenyl, 2-ethylindene, or 1-methyl-3-ethylpyrene, fluorene, biphenyl, indene, naphthalene, or 9,9-dimethylfluorene.

In this application, the alkyl substituent may be an alkyl group well-known by a person skilled in the art, for example, a C₁ to C₆ alkyl group, where the naphthalene, biphenyl, phenanthrene, anthracene, perylene, pyrene, fluorene, and indene each may be substituted by the alkyl group for one or more times.

In some embodiments, in step (1), the solvent includes at least one selected from an aromatic compound, an ether, a furan, a pyran, an ester, or fluoride thereof. Optionally, the solvent includes at least one selected from benzene, pyran, fluoroethylene carbonate, tetrahydrofuran, monoglyme, dimethyl carbonate, ethyl 1, 1,2,2-tetrafluoroethyl ether, or 2-methyltetrahydrofuran.

In this application, the aromatic compound may be those conventionally used in the art, such as benzene, and may be optionally substituted one or more times by at least one of the following substituents: C₁ to C₆ alkyl, fluorine, chlorine, bromine, a cyano group, a nitro group, a hydroxyl group, or a carboxyl group. The ester may be a carbonate ester, and may be optionally substituted one or more times by fluorine, chlorine, bromine, or a cyano group.

In some embodiments, in step (1), the concentration of the reactant in the solvent is 0.01 mol/L to 15 mol/L, optionally 0.03 mol/L to 10 mol/L, and further optionally 0.04 mol/L to 5 mol/L.

In some embodiments, in step (1), the concentration of the lithiation agent is 0.01 mol/L to 15 mol/L, optionally 0.02 mol/L to 10 mol/L, and further optionally 0.03 mol/L to 5 mol/L. Understandably, the concentration of the lithiation agent is the content of the metallic lithium compounded and dissolved in the solvent.

By using the reactant and solvent of this application, this application can ensure that the metallic lithium forms a lithiation agent of an appropriate redox potential.

In some embodiments, in step (1), the metallic lithium is at least one of a lithium block, lithium foil, or lithium powder.

In some embodiments, in step (1), in order to allow the metallic lithium to fully react to form a lithiation agent, an excess amount of metallic lithium is usually added, and then the unreacted metallic lithium is filtered out. For example, the amount of metallic lithium added may be 2 to 20 times the theoretical amount.

In some embodiments, in step (1), a redox potential of the lithiation agent is 0.05 V to 1.0 V, and optionally 0.1 V to 0.5 V.

In this application, by using the reactant and solvent of this application and controlling the concentration of the lithiation agent to fall within the range specified herein, this application can more reliably ensure that the redox potential of the lithiation agent is the desired value. Here, the method for determining the redox potential is well-known to a person skilled in the art, and may be, for example, cyclic voltammetry, in which the standard electrode potential of a standard hydrogen electrode is 0 V.

In some embodiments, in step (1), stirring is performed after adding the metallic lithium, and the stirring continues for a duration of 0.2 h to 12 h, and optionally 1 h to 6 h; and/or, the stirring is performed at a temperature of -10 °C to 70 °C, and optionally 0 to 60 °C; and/or, a molar ratio of the metallic lithium in use to the reactant is (1 to 20): 1, and optionally (2 to 15): 1.

In some embodiments, in step (2), a thickness of the MₙO_{y} layer (where 1 ≤ n ≤ 3, 0 ≤ y ≤ 5) is 2 nm to 3000 nm, and optionally 4 nm to 2500 nm; and/or, a mass per unit area of the MₙO_{y} layer is 0.1 g/m² to 25 g/m², and optionally 1 g/m² to 20 g/m².

Here, understandably, the lithium-philic substance MₙO_{y} can react with the subsequently used lithiation agent to form the alloy layer of this application.

In some embodiments, in step (2), when y in MₙO_{y} is 0, M serving as a lithium-philic substance is a pure element, and a resultant pre-lithiation layer includes a LiₓM alloy layer; and, when 0 < y ≤ 5, the lithium-philic substance is an oxide of M, and a resultant pre-lithiation layer includes a LiₓM alloy inner layer (near the current collector) and a Li₂O outer layer (on one side of the alloy layer, the side being away from the current collector). Therefore, when y = 0, the pre-lithiation layer in this application is an alloy layer. When 0 < y ≤ 5, the pre-lithiation layer in this application is an alloy layer and a lithium oxide layer.

In some embodiments, n is a value greater than or equal to 1 and less than or equal to 3, and optionally, n is a value greater than or equal to 1 and less than or equal to 2; y is a value greater than or equal to 0 and less than or equal to 5, and optionally, y is a value greater than or equal to 0 and less than or equal to 4.

Here, understandably when the lithium-philic substance in use is an oxide of the element M, the lithiation agent reacts with the lithium-philic substance to generate a lithium alloy layer and a lithium oxide layer. When the lithium-philic substance is pure element M, no lithium oxide layer is generated (only a lithium alloy layer is generated). Therefore, when the lithium-philic substance is a pure element and the subsequently used lithiation agent is excessive in amount, the pre-lithiation layer may include an alloy layer and a metallic lithium layer that is located on one side of the alloy layer, the side being away from the current collector. Definitely, when the prepared negative current collector is subsequently exposed to air, the outer lithium layer will also be oxidized to form lithium oxide.

In some embodiments, in step (2), during magnetron sputtering, the current collector is first cleaned by glow discharge. Optionally, the base vacuum level is 1×10⁻⁵ Pa to 1×10⁻³ Pa, and optionally 0.5×10⁻⁵ Pa to 0.5×10⁻³ Pa; and/or, the pressure of the inert gas (such as argon) is 0.5 Pa to 3 Pa, and optionally 1 Pa to 2 Pa; and/or, the power of the radio frequency source is 100 W to 250 W, and optionally 150 W to 200 W. The glow discharge cleaning continues for a duration of 10 to 50 minutes, and optionally 20 to 40 minutes.

In some embodiments, in step (2), the glow-cleaned current collector is conveyed into a sputtering chamber, and then an inert gas (such as argon) is passed into the chamber. Optionally, the pressure of the inert gas is 0.1 Pa to 1 Pa, and optionally 0.2 Pa to 0.5 Pa; and/or, the rotation speed of the specimen pallet is 5 to 15 degrees/second, and optionally 6 to 12 degrees/second; and/or, the bias voltage is -50 V to -150 V, and optionally -60 V to -120 V; and/or, the source power of a metal target containing the metal M or an oxide of M is 100 W to 200 W, and optionally 120 W to 180 W.

In this application, steps (1) and (2) are interchangeable and may be performed simultaneously.

In some embodiments, in step (2), the current collector on which the metal M or an oxide of M is deposited is annealed. Optionally, the temperature of the annealing is 200 °C to 400 °C, and optionally 250 °C to 350 °C; and the duration of the annealing is 1 h to 5 h, and optionally 1.5 h to 4 h.

In some embodiments, in step (3), a redox potential of the lithiation agent is lower than the redox potential of the MₙO_{y} (1 ≤ n ≤ 3, 0 ≤ y ≤ 5) on the current collector.

By controlling the redox potential of the lithiation agent to fall within the range specified herein, this application can ensure that the lithiation agent can more easily lithiate a lithium-philic layer material on the current collector.

In some embodiments, in step (3), the lithiation agent obtained in step (1) is applied to the MₙO_{y} (1 ≤ n ≤ 3, 0 ≤ y ≤ 5) layer, and then the current collector is cleansed with a washing liquid after completion of reaction, and is dried to obtain a current collector containing the pre-lithiation layer.

In some embodiments, in step (3), the lithiation agent is applied to the lithium-philic layer by at least one of dip-coating, brushing, curtain coating, roller coating, nitrogen spraying (spray gun plus compressed nitrogen), air spraying (spray gun plus compressed air), electrostatic spraying, electrophoretic spraying, or high-pressure airless spraying. Optionally, the lithiation agent is applied to the lithium-philic layer by at least one of brushing, curtain coating, nitrogen spraying, or dip-coating.

In some embodiments, in step (3), the reaction temperature is 0 °C to 80 °C, and optionally 10 °C to 50 °C; and/or, the reaction duration is 1 min to 12 h, and optionally 5 min to 6 h, and further optionally 20 min to 3 h.

In some embodiments, in step (3), the washing liquid includes at least one selected from an aromatic compound, an ether, an ester, or a fluorinated product thereof, and optionally includes at least one selected from benzene, dimethyl carbonate, ethylene carbonate, fluoroethylene carbonate, tetrahydrofuran, dimethyl ether, hydrofluoroether, or 1,1,1,3,3,3-hexafluoroisopropyl methyl ether.

In some embodiments, in step (3), the drying temperature is 0 °C to 100 °C, and optionally 10 °C to 80 °C; and/or, the drying duration is 5 min to 6 h, and optionally 10 min to 1 h; and/or, the drying atmosphere is at least one of nitrogen, argon, or air.

In some embodiments, in step (3), the molar ratio of lithium to M in the lithiation agent is (0.1 to 15): 1, optionally (0.5 to 12): 1, or further optionally (2 to 11): 1. However, when the lithiation agent is applied by dip-coating, the molar ratio is not limited.

A third aspect of this application provides a negative electrode plate. The negative electrode plate includes the negative current collector according to the first aspect of this application or a negative current collector prepared by the method according to the second aspect of this application.

A fourth aspect of this application provides a secondary battery. The secondary battery includes at least one of the negative current collector according to the first aspect of this application, a negative current collector prepared by the method according to the second aspect of this application, or the negative electrode plate according to the third aspect of this application.

A fifth aspect of this application provides an electrical device. The electrical device includes the secondary battery according to the fourth aspect of this application.

A secondary battery of this application is described below with due reference to drawings. The secondary battery may be in the form of a battery cell, a battery module, or a battery pack.

In an embodiment of this application, a battery cell is provided.

Generally, a battery cell includes a positive electrode plate, a negative electrode plate, an electrolyte, and a separator. In a charge-discharge cycle of the battery, active ions are shuttled between the positive electrode plate and the negative electrode plate by intercalation and deintercalation. The electrolyte serves to conduct ions between the positive electrode plate and the negative electrode plate. Disposed between the positive electrode plate and the negative electrode plate, the separator primarily serves to prevent a short circuit between the positive electrode plate and the negative electrode plate while allowing passage of ions.

### [Positive electrode plate]

The positive electrode plate includes a positive current collector and a positive electrode film layer that overlays at least one surface of the positive current collector. The positive electrode film layer includes a positive active material.

As an example, the positive current collector includes two surfaces opposite to each other in a thickness direction of the positive current collector. The positive electrode film layer is disposed on either or both of the two opposite surfaces of the positive current collector.

In some embodiments, the positive current collector may be a metal foil or a composite current collector. For example, the metal foil may be aluminum foil. The composite current collector may include a polymer material substrate and a metal layer formed on at least one surface of the polymer material substrate. The composite current collector may be formed by overlaying the polymer material substrate with a metal material (for example, aluminum, aluminum alloy, nickel, nickel alloy, titanium, titanium alloy, silver, and silver alloy). The polymer material substrate may be, for example, polypropylene (PP), polyethylene terephthalate (PET), polybutylene terephthalate (PBT), polystyrene (PS), or polyethylene (PE).

In some embodiments, the positive active material may be a positive active material that is well known for use in a battery in the art. As an example, the positive active material may include at least one of the following materials: olivine-structured lithium-containing phosphate, lithium transition metal oxide, and a modified compound thereof. However, this application is not limited to such materials, and other conventional materials usable as a positive active material of a battery may be used instead. Of such positive active materials, one may be used alone, or at least two may be used in combination. Examples of the lithium transition metal oxide may include, but without being limited to, at least one of lithium cobalt oxide (such as LiCoO₂), lithium nickel oxide (such as LiNiO₂), lithium manganese oxide (such as LiMnO₂ and LiMn₂O₄), lithium nickel cobalt oxide, lithium manganese cobalt oxide, lithium nickel manganese oxide, lithium nickel cobalt manganese oxide (such as LiNi_{1/3}Co_{1/3}Mn_{1/3}O₂ (briefly referred to as NCM333), LiNi_{0.5}Co_{0.2}Mn_{0.3}O₂ (briefly referred to as NCM523), LiNi_{0.5}Co_{0.25}Mn_{0.25}O₂ (briefly referred to as NCM211), LiNi_{0.6}Co_{0.2}Mn_{0.2}O₂ (briefly referred to as NCM622), LiNi_{0.8}Co_{0.1}Mn_{0.1}O₂ (briefly referred to as NCM811), lithium nickel cobalt aluminum oxide (such as LiNi_{0.85}Co_{0.15}Al_{0.05}O₂), or a modified compound thereof. Examples of the olivine-structured lithium-containing phosphate may include, but without being limited to, at least one of lithium iron phosphate (such as LiFePO₄ (briefly referred to as LFP)), a composite of lithium iron phosphate and carbon, lithium manganese phosphate (such as LiMnPO₄), a composite of lithium manganese phosphate and carbon, lithium manganese iron phosphate, or a composite of lithium manganese iron phosphate and carbon.

In some embodiments, the mass percent of the positive active material is 80% to 99%, optionally 84% to 98.5%, based on the total mass of the positive electrode film layer.

In some embodiments, the positive electrode film layer further optionally includes a binder. As an example, the binder may include at least one of polyvinylidene difluoride (PVDF), polytetrafluoroethylene (PTFE), poly(vinylidene fluoride-co-tetrafluoroethylene-co-propylene), poly (vinylidene fluoride-co-hexafluoropropylene-co-tetrafluoroethylene), poly(tetrafluoroethylene-co-hexafluoropropylene), or fluorinated acrylate resin.

In some embodiments, the mass percent of the binder is 0.1% to 4%, optionally 0.5% to 2%, based on the total mass of the positive electrode film layer.

In some embodiments, the positive electrode film layer further optionally includes a conductive agent. As an example, the conductive agent may include at least one of superconductive carbon, acetylene black, carbon black, Ketjen black, carbon dots, carbon nanotubes, graphene, or carbon nanofibers.

In some embodiments, the mass percent of the conductive agent is 0.1% to 8%, optionally 0.5% to 5%, based on the total mass of the positive electrode film layer.

In some embodiments, the positive electrode plate may be prepared according to the following method: dispersing the ingredients of the positive electrode plate such as the positive active material, the conductive agent, the binder, and any other ingredients into a solvent (such as N-methyl-pyrrolidone) to form a positive electrode slurry, coating a positive current collector with the positive electrode slurry, and performing steps such as drying and cold pressing to obtain the positive electrode plate.

### [Negative electrode plate]

The negative electrode plate contains the negative current collector according to the first aspect of this application or a negative current collector prepared by the method according to the second aspect of this application. In other words, the prepared secondary battery may be an anode-free lithium metal battery. Here, the term "anode-free lithium metal battery" may mean a lithium metal battery with a negative current collector that is coated with no negative active material before the first charge.

In some embodiments, the negative electrode plate may also include the negative current collector according to the first aspect of this application or a negative current collector prepared by the method according to the second aspect of this application, and include a negative electrode film layer disposed on at least one surface of the negative current collector. The negative electrode film layer includes a negative active material.

As an example, the negative current collector includes two surfaces opposite to each other in a thickness direction of the negative current collector. The negative electrode film layer is disposed on either or both of the two opposite surfaces of the negative current collector.

In some embodiments, the negative current collector may be a metal foil, a metal mesh, or a composite current collector. For example, the metal foil may be copper foil. The metal mesh may be copper mesh. The composite current collector may include a polymer material substrate and a metal layer formed on at least one surface of the polymer material substrate. The composite current collector may be formed by overlaying the polymer material substrate with a metal material (for example, copper, copper alloy, nickel, nickel alloy, titanium, titanium alloy, silver, and silver alloy). The polymer material substrate may be, for example, polypropylene (PP), polyethylene terephthalate (PET), polybutylene terephthalate (PBT), polystyrene (PS), or polyethylene (PE).

In some embodiments, the negative active material may be a negative active material well-known in the art for use in a battery. As an example, the negative active material may include at least one of the following materials: artificial graphite, natural graphite, soft carbon, hard carbon, silicon-based material, tin-based material, lithium titanium oxide, and the like. The silicon-based material may be at least one selected from elemental silicon, a silicon-oxygen compound, a silicon-carbon composite, a silicon-nitrogen composite, and a silicon alloy. The tin-based material may be at least one selected from elemental tin, a tin-oxygen compound, or a tin alloy. However, this application is not limited to such materials, and other conventional materials usable as a negative active material of a battery may be used instead. One of the negative active materials may be used alone, or at least two thereof may be used in combination.

In some embodiments, the mass percent of the negative active material is 75% to 99%, optionally 80% to 98%, based on the total mass of the negative electrode film layer.

In some embodiments, the negative electrode film layer further optionally includes a binder. The binder may be at least one selected from styrene-butadiene rubber (SBR), polyacrylic acid (PAA), polyacrylic acid sodium (PAAS), polyacrylamide (PAM), polyvinyl alcohol (PVA), sodium alginate (SA), polymethyl acrylic acid (PMAA), and carboxymethyl chitosan (CMCS).

In some embodiments, the mass percent of the binder is 0.1% to 3.5%, optionally 0.5% to 2.5%, based on the total mass of the negative electrode film layer.

In some embodiments, the negative electrode film layer further optionally includes a conductive agent. The conductive agent may be at least one selected from superconductive carbon, acetylene black, carbon black, Ketjen black, carbon dots, carbon nanotubes, graphene, or carbon nanofibers.

In some embodiments, the mass percent of the conductive agent is 0.04% to 5%, optionally 0.5% to 3%, based on the total mass of the negative electrode film layer.

In some embodiments, the negative electrode film layer further optionally includes other agents, such as a thickener (for example, sodium carboxymethyl cellulose (CMC-Na)).

In some embodiments, the negative electrode plate may be prepared according to the following method: dispersing the ingredients of the negative electrode plate such as the negative active material, the conductive agent, and the binder and any other ingredients in a solvent (such as deionized water) to form a negative electrode slurry, coating a negative current collector with the negative electrode slurry, and performing steps such as drying and cold calendering to obtain the negative electrode plate.

### [Electrolyte]

The electrolyte serves to conduct ions between the positive electrode plate and the negative electrode plate. The type of the electrolyte is not particularly limited in this application, and may be selected as required. For example, the electrolyte may be in a liquid state or gel state, or all solid state.

In some embodiments, the electrolyte is an electrolyte solution. The electrolyte solution includes an electrolyte salt and a solvent.

In some embodiments, the electrolyte salt may be at least one selected from lithium hexafluorophosphate, lithium tetrafluoroborate, lithium perchlorate, lithium hexafluoroarsenate, lithium bisfluorosulfonimide, lithium bistrifluoromethanesulfonimide, lithium trifluoromethanesulfonate, lithium difluorophosphate, lithium difluoro(oxalato)borate, lithium bis(oxalato)borate, lithium difluoro(bisoxalato)phosphate, and lithium tetrafluoro(oxalato)phosphate.

In some embodiments, the solvent may be at least one selected from ethylene carbonate, propylene carbonate, ethyl methyl carbonate, diethyl carbonate, dimethyl carbonate, dipropyl carbonate, methyl propyl carbonate, ethylene propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, methyl sulfonyl methane, ethyl methyl sulfone, and (ethylsulfonyl)ethane.

In some embodiments, a concentration of the electrolyte salt in the nonaqueous electrolyte solution is, for example, at least 0.3 mole/liter (mol/L), optionally at least 0.7 mol/L, optionally at most 8 mol/L, optionally at most 1.7 mol/L, and further optionally at most 1.2 mol/L.

In some embodiments, the electrolyte solution further optionally includes an additive. For example, the additive may include a negative electrode film-forming additive or a positive electrode film-forming additive. The additive may further include an additive capable of improving specified performance of the battery, for example, an additive for improving overcharge performance of the battery, or an additive for improving high- or low-temperature performance of the battery.

### [Separator]

In some embodiments, the battery cell further includes a separator. The type of the separator is not particularly limited in this application, and may be any well-known porous separator that is highly stable both chemically and mechanically.

In some embodiments, the separator may be made of a material that is at least one selected from glass fiber, non-woven fabric, polyethylene, polypropylene, and polyvinylidene difluoride. The separator may be a single-layer film or a multilayer composite film, without being particularly limited. When the separator is a multilayer composite film, materials in different layers may be identical or different, without being particularly limited.

In some embodiments, the positive electrode plate, the negative electrode plate, and the separator may be made into an electrode assembly by winding or stacking.

In some embodiments, the battery cell may include an outer package. The outer package may be configured to package the electrode assembly and the electrolyte.

In some embodiments, the outer package of the battery cell may be a hard shell such as a hard plastic shell, an aluminum shell, a steel shell, or the like. Alternatively, the outer package of the secondary battery may be a soft package such as a pouch-type soft package. The soft package may be made of plastic such as polypropylene, polybutylene terephthalate, or polybutylene succinate.

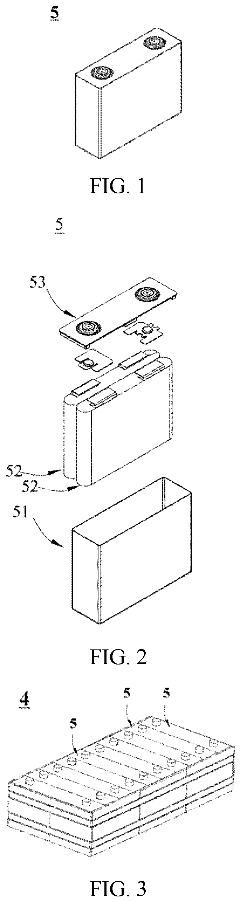

The shape of the battery cell is not particularly limited in this application, and may be cylindrical, prismatic or in any other shape. For example, FIG. 1 shows a prismatic battery cell 5 as an example.

In some embodiments, referring to FIG. 2, the outer package may include a housing 51 and a top cap assembly 53. The housing 51 may include a bottom plate and a side plate connected to the bottom plate. The bottom plate and the side plate close in to form an accommodation cavity. The housing 51 is provided with an opening that communicates to the accommodation cavity. The top cap assembly 53 can fit and cover the opening to close the accommodation cavity. The positive electrode plate, the negative electrode plate, and the separator may be made into the electrode assembly 52 by winding or stacking. The electrode assembly 52 is packaged in the accommodation cavity. The electrolyte solution infiltrates in the electrode assembly 52. The number of electrode assemblies 52 included in a battery cell 5 may be one or more, and may be determined by a person skilled in the art as actually required.

In some embodiments, the battery cell may be assembled into a battery module. The battery module may include one or more battery cells, and the specific number of battery cells in a battery module may be selected by a person skilled in the art depending on the application scenario and capacity of the battery module.

FIG. 3 shows a battery module 4 as an example. Referring to FIG. 3, in the battery module 4, a plurality of battery cells 5 may be arranged sequentially along a length direction of the battery module 4. Alternatively, the secondary batteries may be arranged in any other manner. Further, the plurality of battery cells 5 may be fixed by a fastener.

Optionally, the battery module 4 may further include a shell that provides an accommodation space. The plurality of battery cells 5 are accommodated in the accommodation space.

In some embodiments, the battery cell may be assembled to form a battery pack. In some embodiments, the battery module may be assembled to form a battery pack. The battery pack may include one or more battery modules, and the specific number of battery modules in a battery pack may be selected by a person skilled in the art depending on practical applications and capacity of the battery pack.

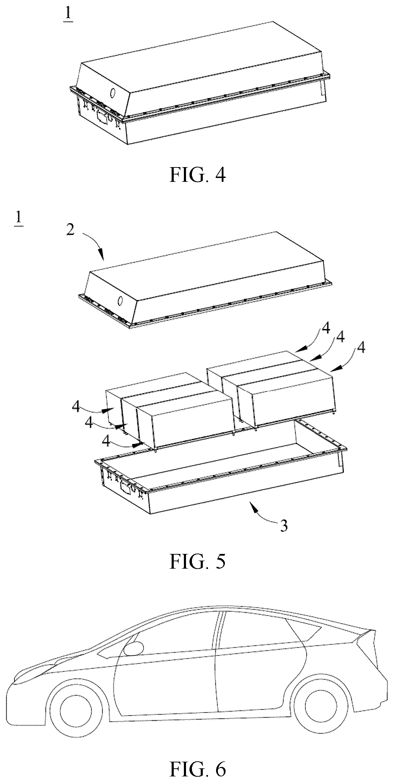

FIG. 4 and FIG. 5 show a battery pack 1 as an example. Referring to FIG. 4 and FIG. 5, the battery pack 1 may include a battery box and a plurality of battery modules 4 disposed in the battery box. The battery box includes an upper box 2 and a lower box 3. The upper box 2 fits the lower box 3 to form a closed space for accommodating the battery modules 4. The plurality of battery modules 4 may be arranged in the battery box in any manner.

Further, this application provides an electrical device. The electrical device includes the secondary battery according to this application. The secondary battery may be used as a power supply of the electrical device, or used as an energy storage unit of the electrical device. The electrical device may include, but without being limited to, a mobile device (such as a mobile phone or a laptop computer), an electric vehicle (such as a battery electric vehicle, a hybrid electric vehicle, a plug-in hybrid electric vehicle, an electric bicycle, an electric scooter, an electric golf cart, or an electric truck), an electric train, a ship, a satellite system, or an energy storage system.

The secondary battery may be selected for use in the electrical device according to the use requirements.

FIG. 6 shows an electrical device as an example. The electrical device may be a battery electric vehicle, a hybrid electric vehicle, a plug-in hybrid electric vehicle, or the like. The electrical device may adopt a battery pack or a battery module in order to meet the requirements of the electrical device on a high power and a high energy density of the secondary battery.

In another example, the device may be a mobile phone, a tablet computer, a notebook computer, or the like. The device is generally required to be thin and light, and may use a battery cell as a power supply.

### Embodiments

The following describes some embodiments of this application. The embodiments described below are illustrative, and are merely intended to construe this application but not to limit this application. Unless techniques or conditions are otherwise expressly specified in an embodiment hereof, the techniques or conditions described in the literature in this field or in an instruction manual of the product are applicable in the embodiment. A reagent or instrument used herein without specifying a manufacturer is a conventional product that is commercially available in the market.

### Embodiment 1

### Preparing a negative current collector

(1) Dissolving 0.05 mol of fluorene in 1 L of tetrahydrofuran solvent, adding 0.5 mol of lithium block, stirring at 20 °C for 0.2 h, filtering out the unreacted excess metallic lithium, and obtaining a lithiation agent with a concentration of 0.05 mol/L (the potential of the lithiation agent is 0.3 V).
(2) a. Placing a mechanically polished copper current collector into ethanol, performing ultrasonication for 10 minutes, and then putting the ultrasonicated product into an acetone solution, performing ultrasonication again for 7 minutes, and then blow-drying the current collector by using nitrogen; b. placing the pretreated current collector into an exchange chamber of the processing equipment, and vacuumizing the chamber until the specified base vacuum level of 1×10⁻⁴ Pa; at the same time, loading an Al target into the sputtering chamber, and adjusting the tilt angle of the target; vacuumizing the sputtering chamber until the specified base vacuum level of 1×10⁻⁴ Pa; c. introducing argon into the exchange chamber, adjusting the gas pressure to 1.5 Pa, and cleaning the polished surface of the current collector for 30 minutes by using a radio frequency power glow discharge at power of 175 W; d. conveying the glow-cleaned current collector into the sputtering chamber, introducing argon into the sputtering chamber, and adjusting the gas pressure to 0.3 Pa, and starting rotation of the specimen pallet at a constant speed of 10 degrees per second; adjusting the bias voltage to -100 V, and adjusting the direct-current source power of the Al target to 150 W, and then opening the specimen stage baffle to deposit an Al film on the substrate for a specified duration, and then turning off the power supply to the Al target, turning off the bias voltage, closing the specimen stage baffle, and taking out the specimen; e. annealing the resultant specimen in a nitrogen atmosphere at a temperature of 300 °C for a duration of 2.5 h, heating the furnace with the specimen, cooling the furnace with the specimen until room temperature, and then taking out the specimen to obtain a current collector with 20 nm-thick aluminum layer (with a mass per unit area being 0.1 g/m²) deposited on one surface.
(3) Brushing 37 mL of the resultant lithiation agent evenly onto the aluminum layer of the resultant current collector (the molar ratio of Li to Al is 5: 1). Letting the lithiation agent react at 30 °C for 5 min, and then cleansing the current collector by using tetrahydrofuran, and drying the current collector at 40 °C in a nitrogen atmosphere for 30 minutes to obtain a current collector 1 containing a Li₃Al alloy layer. The thickness of the Li₃Al alloy layer is 30 nm, and the mass per unit area is 0.21 g/m².

### Preparing a full cell

Punching the prepared negative current collector into a circular electrode plate, and mixing the positive active material LiFePO₄, the conductive agent acetylene black (SP), and the binder PVDF at a ratio of 84: 8: 8. Adding N-methylpyrrolidone (NMP). Applying the mixed slurry (in which the solid content is 70 wt%) onto carbon-coated aluminum foil to make a positive electrode plate. Assembling the positive electrode plate, the resultant negative current collector, and the separator to form a cell, and injecting an electrolyte solution (4 mol/L lithium bis(fluorosulfonyl)imide LiFSI/monoglyme DME) to make a full cell (CR2032).

### Embodiments 2 to 7

The preparation method is similar to that in Embodiment 1 except the differences set out in Table 1.

### Embodiment 8

The preparation method is similar to that in Embodiment 1 except the method for preparing a negative current collector, as described below:
(1) Dissolving 1 mol of 2,2-dimethylbiphenyl in 1 L of monoglyme, adding 4 mol of lithium sheet, stirring at 50 °C for 2 h, filtering out the unreacted excess metallic lithium, and obtaining a lithiation agent with a concentration of 1 mol/L (the potential of the lithiation agent is 0.13 V).
(2) a. Placing a copper current collector cleaned with concentrated hydrochloric acid and polished into ethanol, performing ultrasonication for 10 minutes, and then putting the ultrasonicated product into an acetone solution, performing ultrasonication again for 7 minutes, and then blow-drying the current collector by using nitrogen; b. placing the pretreated current collector into an exchange chamber of the processing equipment, and vacuumizing the chamber until the specified base vacuum level of 1×10⁻⁴ Pa; at the same time, loading a SiO target into the sputtering chamber, and adjusting the tilt angle of the target; vacuumizing the sputtering chamber until the specified base vacuum level of 1×10⁻⁴ Pa; c. introducing argon into the exchange chamber, adjusting the gas pressure to 1.5 Pa, and cleaning the polished surface of the current collector for 30 minutes by using a radio frequency power glow discharge at power of 170 W; d. conveying the glow-cleaned current collector into the sputtering chamber, introducing argon into the sputtering chamber, and adjusting the gas pressure to 0.3 Pa, and starting rotation of the specimen pallet at a constant speed of 10 degrees per second; adjusting the bias voltage to -100 V, and adjusting the direct-current source power of the SiO target to 150 W, and then opening the specimen stage baffle to deposit a SiO film on the substrate for a specified duration, and then turning off the power supply to the SiO target, turning off the bias voltage, closing the specimen stage baffle, and taking out the specimen; e. annealing the resultant specimen in a nitrogen atmosphere at a temperature of 300 °C for a duration of 2.5 h, heating the furnace with the specimen, cooling the furnace with the specimen until room temperature, and then taking out the specimen to obtain a current collector containing SiO (with a mass per unit area being 3 g/m², and a thickness being 500 nm).
(3) Immersing the resultant SiO-containing current collector in the resultant lithiation agent, reacting at 20 °C for 2 hours, and then cleansing the current collector by using tetrahydrofuran. Drying the current collector at 0 °C in a nitrogen atmosphere for 2 hours to obtain a current collector 8 containing a Li_{4.4}Si alloy inner layer and a Li₂O outer layer. The Li_{4.4}Si alloy layer is 600 nm thick, and 3.5 g/m² in mass per unit area. The Li₂O layer is 300 nm thick, and 3.0 g/m² in mass per unit area.

### Embodiment 9

The preparation method is similar to that in Embodiment 8 except the differences set out in Table 1.

### Comparative Embodiment 1

The preparation method is similar to that in Embodiment 1 except that the negative current collector is copper foil that is not treated by the method disclosed herein.

### Test methods

### First-cycle Coulombic efficiency and cycle capacity retention rate of the full-cell

The performance of the full-cell is tested by using a high-precision battery test system (model: BTS-5V10mA, manufactured by Shenzhen Neware Electronics Co., Ltd.) according to the following procedure: (1) leaving the cell to stand for 6 hours; (2) charging the cell at a constant current of 0.1C until the voltage reaches 3.65 V, and then charging the cell at a constant voltage until the current drops to 0.05C, and recording the charge capacity at this time as C₀; (3) leaving the cell to stand for 5 minutes; (4) discharging the cell at a constant current of 0.2C until the voltage drops to 2 V, and then discharging the cell at a constant voltage until the current drops to 0.05C, and recording the charge capacity at this time as D₀; (5) leaving the cell to stand for 5 minutes; (6) charging the cell at a constant current of 0.2C until the voltage reaches 3.65 V, and then charging the cell at a constant voltage until the current drops to 0.05C; (7) leaving the cell to stand for 5 minutes; (8) discharging the cell at a constant current of 0.5C until the voltage drops to 2 V; (9) leaving the cell to stand for 5 minutes; (10) repeating steps (6) to (9) for 10 cycles; (11) charging the cell at a constant current of 0.1C until the voltage reaches 3.65 V, and then charging the cell at a constant voltage until the current drops to 0.05C; (12) leaving the cell to stand for 5 minutes; (13) discharging the cell at a constant current of 0.2C until the voltage drops to 2 V; (14) leaving the cell to stand for 5 minutes; (15) repeating steps (6) to (13) for 5 cycles; and (16) recording the discharge capacity at the end of the n^{th} cycle as Dₙ. The first-cycle Coulombic efficiency and the n^{th}-cycle capacity retention rate are calculated as: first-cycle Coulombic efficiency = D₀/C₀ × 100%; the n^{th}-cycle capacity retention rate = Dₙ/D₀ × 100%. The test results are shown in Table 2 below.

**Table 1 (To be continued)**

| Embodiment | Reactant | Solvent (1 L) | Lithium | Amount of lithium (mol) | Stirring duration (h) | Stirring temperature (°C) |
|---|---|---|---|---|---|---|
| 1 | 0.05 mol of Fluorene | Tetrahydrofuran | Lithium block | 0.5 | 0.2 | 20 |
| 2 | 1 mol of biphenyl | Monoglyme | Lithium sheet | 4 | 12 | 10 |
| 3 | 1 mol of biphenyl | Monoglyme | Lithium sheet | 4 | 12 | 10 |
| 4 | 1 mol of biphenyl | Monoglyme | Lithium sheet | 4 | 12 | 10 |
| 5 | 10 mol of indene | 2-methyl tetrahydrofuran | Lithium powder | 20 | 6 | 40 |
| 6 | 4 mol of naphthalene | Dimethyl carbonate | Lithium sheet | 1 | 2 | 0 |
| 7 | 3 mol of 9,9-dimethyl fluorene | ethyl 1,1,2,2-tetrafluoroethyl ether | Lithium powder | 1 | 1 | 60 |
| 8 | 1 mol of 2,2-dimethyl biphenyl | Monoglyme | Lithium sheet | 4 | 2 | 50 |
| 9 | 6 mol of 2,2-dimethyl biphenyl | 2-methyl tetrahydrofuran | Lithium sheet | 6 | 4 | 30 |
| Comparative Embodiment 1 | - | - | - | - | - | - |

**Table 1 (Continued)**

| Embodiment | Concentration of lithiation agent (m/L) | Potential of lithiation agent (V) | Thickness (nm) of lithium-philic substance MₙO_{y} and mass per unit area (g/m²) | Applying method and reaction ratio (Li/M) | Reaction temperature (°C) | Reaction duration |
|---|---|---|---|---|---|---|
| 1 | 0.05 | 0.30 | Al (20, 0.1) | Brushing (5: 1) | 30 | 5 min |
| 2 | 1 | 0.33 | Al (200, 1) | Curtain coating (10: 1) | 30 | 10 min |
| 3 | 1 | 0.33 | Al (1000, 5) | Compressed nitrogen spraying (10: 1) | 30 | 10 min |
| 4 | 1 | 0.33 | Al₂O₃ (1200, 10) | Brushing (5: 1) | 30 | 10 min |
| 5 | 10 | 0.10 | Sn (2000, 20) | Dip-coating | 50 | 6 h |
| 6 | 2 | 0.15 | P (1200, 5) | Dip-coating | 80 | 30 min |
| 7 | 3 | 0.18 | Si (700, 3) | Dip-coating | 40 | 1 h |
| 8 | 1 | 0.13 | SiO (500, 3) | Dip-coating | 20 | 2 h |
| 9 | 6 | 1.0 | C (600, 1.0) | Dip-coating | 10 | 1 min |
| Comparative Embodiment 1 | - | - | - | - | - | - |

**Table 1 (Continued)**

| Embodiment | Washing liquid | Drying temperature (°C) | Drying duration | Drying atmosphere | Pre-lithiation layer substance and thickness (nm) thereof and mass per unit area (g/m²) |
|---|---|---|---|---|---|
| 1 | Tetrahydrofuran | 40 | 30 min | Nitrogen | Li₃Al (30, 0.21) |
| 2 | Monoglyme | 80 | 5 min | Argon | Li₃Al (300, 2.1) |
| 3 | Monoglyme | 80 | 5 min | Argon | Li₃Al (1500, 10.4) |
| 4 | Monoglyme | 30 | 6 h | Argon | Li₃Al (1600, 11.0) |
| | | | | | Li₂O (500, 8.8) |
| 5 | 2-methyl tetrahydrofuran | 40 | 1 h | Nitrogen | Li_{4.4}Sn (5000, 27.1) |
| 6 | Monoglyme | 60 | 30 min | Nitrogen | Li₃P (1700, 9.7) |
| 7 | Dimethyl carbonate | 80 | 1 h | Argon | Li_{4.4}Si (2500, 7.5) |
| 8 | Tetrahydrofuran | 0 | 2 h | Nitrogen | Li_{4.4}Si (600, 3.5) |
| | | | | | Li₂O (300, 3.0) |
| 9 | Mixture of fluoroethylene carbonate and monoglyme mixed at 1: 1 | 30 | 10 min | Air | LiC₆ (700, 1.1) |
| Comparative Embodiment 1 | - | - | - | - | - |

**Table 2**

| | First-cycle Coulombic efficiency of full-cell (%) | 50^{th}-cycle capacity retention rate of full-cell (%) |
|---|---|---|
| Embodiment 1 | 72.6 | 73.8 |
| Embodiment 2 | 77.2 | 78.6 |
| Embodiment 3 | 93.4 | 74.4 |
| Embodiment 4 | 91.5 | 73.6 |
| Embodiment 5 | 92.2 | 80.5 |
| Embodiment 6 | 93.6 | 80.3 |
| Embodiment 7 | 88.4 | 83.2 |
| Embodiment 8 | 80.6 | 85.6 |
| Embodiment 9 | 73.5 | 87.6 |
| Comparative Embodiment 1 | 50.1 | 54.2 |

As can be seen from Table 2 above, the negative current collector of this application can improve the first-cycle Coulombic efficiency and cycle capacity retention rate of the secondary battery significantly.

It is hereby noted that this application is not limited to the foregoing embodiments. The foregoing embodiments are merely examples. Any and all embodiments with substantively the same constituents or exerting the same effects as the technical ideas hereof without departing from the scope of the technical solutions of this application still fall within the technical scope of this application. In addition, all kinds of variations of the embodiments conceivable by a person skilled in the art and any other embodiments derived by combining some constituents of the embodiments hereof without departing from the subject-matter of this application still fall within the scope of this application.

## Claims

1. A negative current collector, wherein at least one surface of the negative current collector is overlaid with a LiₓM alloy layer, in which 0 < x ≤ 5 and M comprises at least one selected from Group III elements, Group IV elements, magnesium, zinc, vanadium, iron, cobalt, phosphorus, or sulfur.

2. The negative current collector according to claim 1, wherein a thickness of the alloy layer is 5 nm to 6000 nm, and optionally 10 nm to 5000 nm.

3. The negative current collector according to claim 1 or 2, wherein a mass per unit area of the alloy layer is 0.10 g/m² to 35 g/m², and optionally 0.20 g/m² to 30 g/m².

4. The negative current collector according to any one of claims 1 to 3, wherein a lithium oxide layer is further disposed on one side of the alloy layer, the side being away from the current collector; and a thickness of the lithium oxide layer is 1 nm to 1000 nm, and optionally 10 nm to 800 nm.

5. The negative current collector according to claim 4, wherein a mass per unit area of the lithium oxide layer is 0.5 g/m² to 20 g/m², and optionally 1 g/m² to 10 g/m².

6. The negative current collector according to any one of claims 1 to 5, wherein the current collector is at least one selected from copper foil, copper mesh, or foamed copper.

7. A method for preparing a negative current collector, wherein the method comprises the following steps:
(1) dissolving a reactant in a solvent, and then adding metallic lithium to obtain a lithiation agent;
(2) depositing a MₙO_{y} (wherein 1 ≤ n ≤ 3, 0 ≤ y ≤ 5) layer on the current collector by magnetron sputtering to obtain a current collector containing a lithium-philic layer, wherein M comprises at least one selected from Group III elements, Group IV elements, magnesium, zinc, vanadium, iron, cobalt, phosphorus, or sulfur; and
(3) applying the lithiation agent obtained in step (1) to the lithium-philic layer obtained in step (2), so as to obtain a current collector containing a pre-lithiation layer.

8. The method according to claim 7, wherein, in step (1), the lithiation agent is a lithium-reactant-solvent complex.

9. The method according to claim 7 or 8, wherein, in step (1), the reactant comprises at least one selected from naphthalene, biphenyl, phenanthrene, anthracene, perylene, pyrene, fluorene, indene, or an alkyl substituent thereof; and optionally, the reactant comprises at least one selected from fluorene, biphenyl, indene, naphthalene, 9,9-dimethylfluorene, or 2,2-dimethylbiphenyl.

10. The method according to any one of claims 7 to 9, wherein, in step (1), the solvent comprises at least one selected from an aromatic compound, an ether, a furan, a pyran, an ester, or fluoride thereof; and optionally, the solvent comprises at least one selected from tetrahydrofuran, monoglyme, dimethyl carbonate, ethyl 1,1,2,2-tetrafluoroethyl ether, or 2-methyltetrahydrofuran.

11. The method according to any one of claims 7 to 10, wherein, in step (1), a redox potential of the lithiation agent is 0.05 V to 1.0 V, and optionally 0.1 V to 0.5 V.

12. The method according to any one of claims 7 to 11, wherein, in step (1), stirring is performed after adding the metallic lithium, and the stirring continues for a duration of 0.2 h to 12 h, and optionally 1 h to 6 h; and/or, the stirring is performed at a temperature of -10 °C to 70 °C, and optionally 0 °C to 60 °C; and/or, a molar ratio of the metallic lithium to the reactant is (1 to 20): 1, and optionally (2 to 15): 1.

13. The method according to any one of claims 7 to 12, wherein, in step (2), a thickness of the MₙO_{y} layer is 2 nm to 3000 nm, and optionally 4 nm to 2500 nm; and/or, a mass per unit area of the MₙO_{y} layer is 0.1 g/m² to 25 g/m², and optionally 1 g/m² to 20 g/m².

14. The method according to any one of claims 7 to 13, wherein, in step (2), when y in MₙO_{y} is 0, M serving as a lithium-philic substance is a pure element, and a resultant pre-lithiation layer comprises a LiₓM alloy layer; and, when 0 < y ≤ 5, the lithium-philic substance is an oxide of M, and a resultant pre-lithiation layer comprises a LiₓM alloy inner layer and a Li₂O outer layer.

15. The method according to any one of claims 7 to 14, wherein, in step (3), the lithiation agent obtained in step (1) is applied to the MₙO_{y} (wherein 1 ≤ n ≤ 3, 0 ≤ y ≤ 5) layer, and then the current collector is cleansed with a washing liquid after complete reaction, and is dried to obtain a current collector containing the pre-lithiation layer.

16. The method according to any one of claims 7 to 14, wherein, in step (3), the lithiation agent is applied to the lithium-philic layer by at least one of dip-coating, brushing, curtain coating, roller coating, nitrogen spraying, air spraying, electrostatic spraying, electrophoretic spraying, or high-pressure airless spraying.

17. A negative electrode plate, comprising the negative current collector according to any one of claims 1 to 6 or a negative current collector prepared by the method according to any one of claims 7 to 16.

18. A secondary battery, comprising the negative electrode plate according to claim 17.

19. An electrical device, comprising the secondary battery according to claim 18.
